Europäisches Patentamt

European Patent Office

Office européen des brevets

(11) Publication number: **0 239 841 B1**

## EUROPEAN PATENT SPECIFICATION

(45) Date of publication of patent specification: **20.05.92**  (51) Int. Cl.⁵: **H03K 19/094**, H03K 19/0175

(21) Application number: **87103438.5**

(22) Date of filing: **10.03.87**

(54) **Voltage output circuit.**

(30) Priority: **31.03.86 JP 72905/86**

(43) Date of publication of application:
**07.10.87 Bulletin 87/41**

(45) Publication of the grant of the patent:
**20.05.92 Bulletin 92/21**

(84) Designated Contracting States:
**DE FR GB**

(56) References cited:
**EP-A- 0 068 883
US-A- 4 437 171
US-A- 4 453 095**

**U Tietzke, CH. Schenk
"Halbleiter-Schaltungstechnik", 1980, page
355**

(73) Proprietor: **KABUSHIKI KAISHA TOSHIBA
72, Horikawa-cho Saiwai-ku
Kawasaki-shi Kanagawa-ken 210(JP)**

(72) Inventor: **Tsugaru, Kazunori c/o Patent Division
Kabushiki Kaisha Toshiba 1-1 Shibaura
1-chome
Minato-ku Tokyo 105(JP)**
Inventor: **Sugimoto, Yasuhiro c/o Patent Division
Kabushiki Kaisha Toshiba 1-1 Shibaura
1-chome
Minato-ku Tokyo 105(JP)**

(74) Representative: **Henkel, Feiler, Hänzel & Partner
Möhlstrasse 37
W-8000 München 80(DE)**

**Description**

This invention relates to a CMOS (Complementary MOS) to ECL (Emitter Coupled Logic) level shifter for converting a desired logic level from CMOS to ECL.

As this type of output circuit, TTL-ECL translators are known in the art. Such an output circuit, however, requires both a positive power supply (for example, +5 volts) for driving a CMOS circuit or a TTL circuit and a negative power supply (for example, -5.2 V) for driving an ECL circuit. This is not desirable from the standpoint of costs. Furthermore, owing to the use of the positive and negative power supplies, elements in the circuit are required to have a breakdown voltage enough great for the sum of both the power supply voltages. Where that output circuit and other circuits are formed on a common chip, they are also required to have a breakdown voltage enough great for the sum of both the power supply voltages.

In summary, the conventional output circuit for converting a CMOS or a TTL level voltage signal to an ECL level voltage signal requires both the positive and negative power supplies and, furthermore, when it is formed, together with said other circuit, the latter circuit is also required to have a breakdown voltage enough great for the aforementioned sum voltages.

Prior art document US-A-4 437 171 discloses a CMOS buffer in which a CMOS level potential is shifted to an ECS level potential. This prior art buffer comprises a first power source, a second power source, and a third power source. An emitter-follower connected bipolar transistor is connected between the first power source and the second power source. A bias circuit is arranged between the first power source and the third power source to output a bias voltage to the base of the emitter-follower connected transistor. Finally, MOS transistors control the level of the bias voltage of the bias circuit according to an input signal. In this buffer circuit, the first power source is a ground potential, the second power source is a negative potential, and the third power source is also a negative potential.

It is accordingly the object of this invention to provide a CMOS to ECL level shifter comprised of a semiconductor integrated circuit including MOS and bipolar type elements, which operates with standard CMOS and ECL power supply levels and which can provide an ECL level voltage output.

To solve this object the present invention provides a CMOS to ECL level shifter as stated in claim 1.

This invention can be more fully understood from the following detailed description when taken in conjunction with the accompanying drawings, in which:

Fig. 1 is a basic circuit diagram showing a CMOS to ECL level shifter according to this invention;

Fig. 2 is a circuit diagram of a CMOS to ECL level shifter according to an embodiment of the present invention; and

Fig. 3 is a characteristic curve showing a relation of a CMOS input level and an ECL output level with respect to time, of the voltage output circuit of Fig. 2.

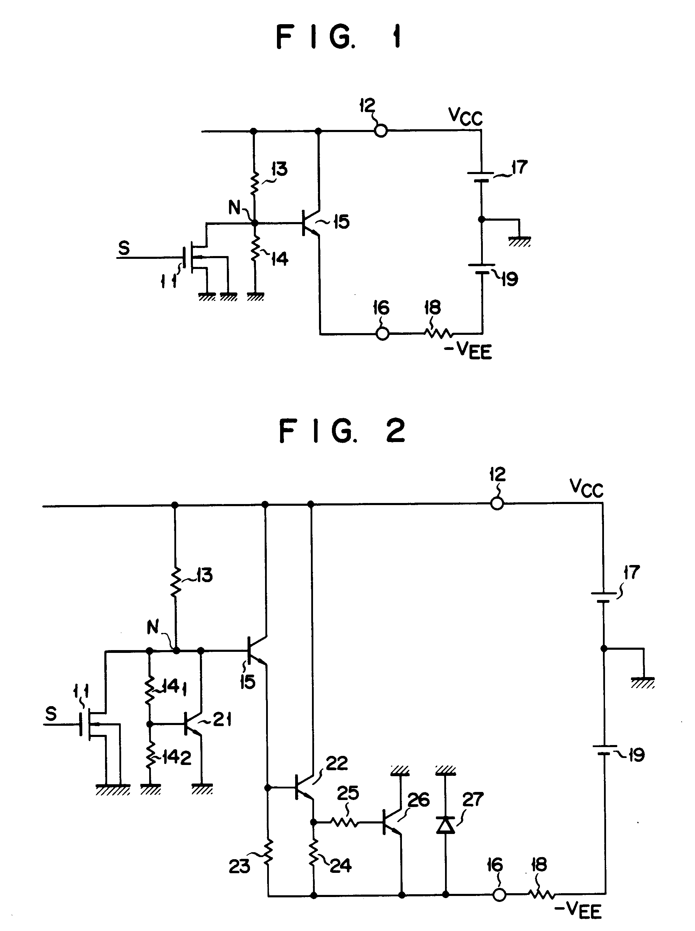

The fundamental arrangement of a CMOS to ECL level shifter according to this invention is as shown in Fig. 1. A signal S from an internal circuit is supplied to the gate of N-channel type MOS transistor 11. One end of MOS transistor 11 is connected to a node N of resistors 13 and 14 in a series array between power supply terminal 12 and ground and the other end and back gate of MOS transistor 11 are grounded. NPN type bipolar transistor 15 is connected at its base to the node N, at its collector to power supply terminal 12 and at its emitter, to output terminal 16. The positive polarity terminal of power supply 17 is connected to power supply terminal 12 where a positive voltage $V_{CC}$ is supplied by power supply 17. The negative polarity terminal of power supply 19 is connected through load resistor 18 to output terminal 16 where a negative voltage $-V_{EE}$ is supplied by power supply 19. The negative polarity terminal of power supply 17 and positive polarity terminal of power supply 19 are grounded.

The operation of the CMOS to ECL level shifter shown in Fig. 1 will be explained below.

When the signal S is at a high level, then MOS transistor 11 is turned ON. When the signal S is at a low level, then MOS transistor 11 is turned OFF. With the resistive values of resistors 13 and 14 represented by R13 and R14, respectively, a voltage on the node N is shifted between

$$\frac{R14 \cdot V_{CC}}{R13 + R14}$$

and the ground by operating MOS transistor ll in an ON/OFF fashion in accordance with a signal S coming from the internal circuit. Specifically, when transistor ll is turned OFF by the signal S, a base voltage on NPN transistor l5 becomes approximately

$$\frac{R14 \cdot V_{CC}}{R13 + R14}$$

when transistor ll is turned ON, a base voltage of NPN transistor l5 becomes the ground voltage. Thus a voltage on output terminal l6 is shifted between

$$\frac{R14 \cdot V_{CC}}{R13 + R14} - V_{BE15}$$

and $-V_{BEl5}$. Where $V_{BEl5}$ denotes a base-emitter voltage of NPN transistor l5. As clearly be understood from the above, output circuit of Fig. l produces a small negative output while operating with a positive power supply alone. The circuit elements in output circuit require the breakdown voltage only for the positive power supply voltage $V_{CC}$.

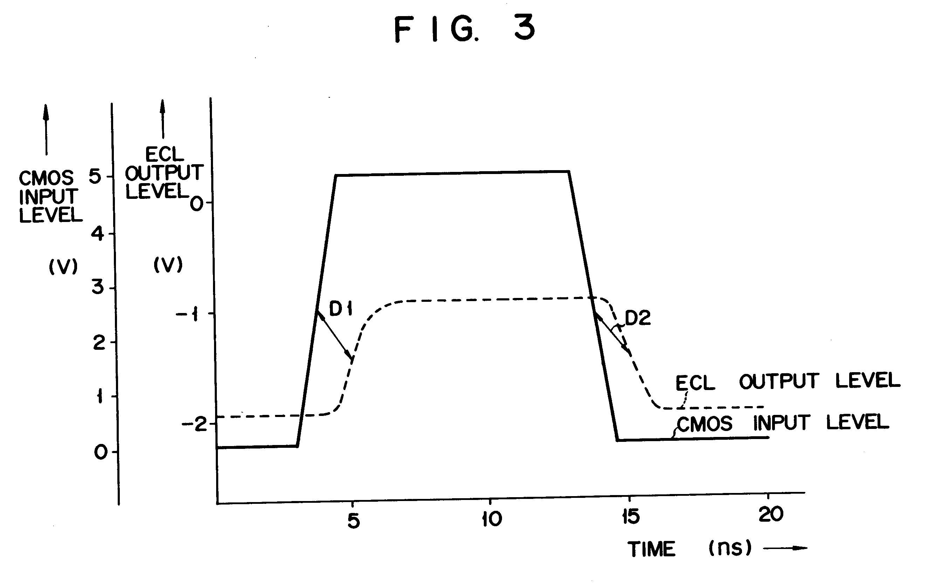

A CMOS to ECL level shifter according to an embodiment of this invention will be explained below with reference to Figs. 2 and 3. Same reference characters used in Figs. l and 2 denote same components.

A CMOS level signal S from the internal circuit is supplied to the gate of an N-channel type MOS transistor ll. MOS transistor ll is connected at one end to the base of NPN type bipolar transistor l5 and grounded at the other end and back gate. Transistor l5 is connected at its collector to power supply terminal l2 and at its base to a node N. A resistor l3 is connected across the base and the collector of transistor l5. A series circuit of resistors $14_1$ and $14_2$ is connected across the base of transistor l5 and ground. A node of resistors $14_1$ and $14_2$ in series connection is connected to the base of NPN type bipolar transistor 2l which is connected between the base of transistor l5 and ground. Transistor l5 is connected at its emitter to the base of NPN type bipolar transistor 22 and to one end of resistor 23. Transistor 22 is connected at its collector to power supply terminal l2 and at its emitter to one end of each of resistors 24 and 25. Output terminal l6 is connected to the other end of each of resistors 23 and 24. NPN type bipolar transistor 26 is connected at its base to the other end of resistor 25, at its emitter to output terminal. The collector of NPN type bipolar transistor 26 is grounded. A combination of transistors 22 and 26 is connected to transistor l5 in a Darlington configuration. An electric current flowing through transistors 22 and 26 is supplied to output terminal l6. Diode 27 is connected across output terminal l6 and ground with the anode connected to output terminal l6 and the cathode grounded. A positive voltage $V_{CC}$ is supplied from power supply l7 to power supply terminal l2 and a negative voltage $-V_{EE}$ is applied from power supply l9 through load resistor l8 to output terminal l6. The, negative polarity terminal of power supply l7 and positive polarity terminal of power supply l9 are grounded. Resistor 25 is used for waveform rectification and diode 27 is used for surge voltage protection.

The operation of the aforementioned circuit will now be explained below.

With Rl and R2 representing the resistive values of resistors $14_1$ and $14_2$, respectively, when transistor ll is turned OFF, a base voltage on NPN transistor l5 becomes approximately.

$(Rl + R2)V_{BE}/R2$ ,

which is made constant irrespective of the power supply voltage $V_{CC}$. $V_{BE}$ denotes a base-emitter voltage of NPN transistor 21. When transistor ll is turned ON, a base voltage on NPN transistor l5 becomes the ground voltage. In other words, that base voltage undergoes a transient shift between the ground voltage and the voltage

$(Rl + R2)V_{BE}/R2$

In accordance with the ON or the OFF state of MOS transistor ll.

Let it be assumed that the signal S from the internal circuit is at a high level. Then MOS transistor ll is turned ON and thus the base voltage of transistor l5 becomes grounded. This voltage level is dropped across respective base-to-emitter paths of transistors l5, 22 and 26 so that a small negative voltage $-3V_{BE}$ appears from output terminal l6. $V_{BE}$ denotes a base-emitter voltage of each of the transistors l5, 22 and 26.

With the signal S at a low level, MOS transistor ll is turned OFF and the base voltage on transistor l5 becomes:

$(Rl + R2)V_{BE}/R2$

3

EP 0 239 841 B1

This voltage is dropped across the base-to-emitter paths of transistors I5, 22 and 26 so that a small voltage

$$(RI + R2)V_{BE}/R2 - 3V_{BE}$$

emerges from output terminal I6.

In the CMOS to ECL level shifter of Fig. 2, NPN transistors I5, 22 and 26 are used to produce an output voltage of an ECL level. Base-emitter voltage $V_{BE}$ of a bipolar transistor decreases as an ambient temperature increases. In the output circuit, the base voltage of NPN transistor I5 drops by a total value, $-3V_{BE}$, of NPN transistors I5, 22 and 23, rendering the output voltage on output terminal I6 small. The bias circuit comprising resistors $I4_1$ and $I4_2$ and NPN transistor 2I is used to decrease the base voltage of NPN transistor I5 when an ambient temperature increases so that, for the temperature variation, the output voltage on output terminal I6 is compensated.

Fig. 3 shows the result of simulation performed on the CMOS level input and ECL output level characteristics of the circuit of Fig. 2 through the use of an SPICE simulation program, noting that $V_{CC}$ = 5 V, $-V_{EE}$ = -2 V, RI8 = 50 Ω and the signal S is a pulse signal whose rise and fall times are I.5 ns each and which varies between 0 V and 5 V.

As understood from Fig. 3, the voltage output circuit of Fig. 2 operates with power supply and converts the CMOS level voltage signal to the ECLL level voltage output. A very high speed is achieved for the conversion times DI and D2 of about I.3 ns in comparison with that (about 5 to 6 ns) of the conventional circuit.

As set forth above, according to this invention a semiconductor CMOS to ECL level shifter including MOS and bipolar elements is provided, which operates with the use of only one positive power supply and converts the CMOS or the TTL level voltage signal to the ECL level voltage signal.

**Claims**

1. A CMOS to ECL level shifter for converting a desired logic level from CMOS to ECL, wherein:
   - a reference potential (GROUND) supplied from a reference potential source corresponds to the low-level of a CMOS input signal (S) from an internal circuit;
   - said CMOS input signal (S) is applied to the gate of a MOS transistor (11), the source of which is connected to the reference potential (GROUND), and the drain of which is connected to the base of the emitter-follower connected first bipolar transistor (15);
   - the emitter of said first bipolar transistor (15) is connected, via a load resistor (18) to a negative supply voltage (19) and a positive supply voltage (17) substantially equal or higher than the high-level of the CMOS input signal is applied to the collector of said first bipolar transistor (15);
   - a bias current is applied to the base of said first bipolar transistor (15) by a voltage divider (12, 14) connected between the positive supply voltage (17) and said reference potential (GROUND); and
   - the ECL output signal is taken from the emitter (16) of said first bipolar transistor (15).

2. The CMOS to ECL level shifter according to claim 1, characterized in that:
   said voltage divider comprises first and second resistors (13, 14) connected in series between said positive supply voltage (17) and said reference potential (GROUND), and
   a node (N) between said first and second resistors (13,14) is connected to the base of said first bipolar transistor (15) whereby a voltage on said node (N) is controlled by said MOS transistor (11).

3. The CMOS to ECL level shifter according to claim 1, characterized in that said voltage divider comprises:
   a first resistor (13) connected between said positive supply voltage (17) and the base of said first bipolar transistor (15);
   second and third resistors ($14_1$, $14_2$) connected in series between the base of said bipolar transistor (15) and said reference potential (GROUND); and
   a second bipolar transistor (21) connected between the base of said first bipolar transistor (15) and said reference potential (GROUND), having its base connected to said node between said second and third resistors ($14_1$, $14_2$).

4. The CMOS to ECL level shifter according to claim 1 or 3, characterized by further comprising:
   a plurality of third bipolar transistors (22, 26) darlington-connected in a cascade fashion to said first bipolar transistor (15).

4

**5.** The CMOS to ECL level shifter according to claim 2, characterized in that:
the ECL output signal undergoes a transient shift between

$$\frac{R14.Vcc}{R13+R14} - VBE15 \quad and \quad -VBE15$$

where
Vcc: the potential of the positive supply voltage (17), R13 and R14: resistance values of said first and second resistors (13, 14), and
VBE15: a potential difference across the base and emitter path of said first bipolar transistor (15).

**6.** The CMOS to ECL level shifter according to claim 4, characterized in that:
the ECL output signal undergoes a transient shift between

$$\frac{(R1+R2)VBE}{R2} - VBEtotal \quad and \quad -VBEtotal$$

where
R1 and R2: resistance values of said second and third resistors ($14_1$, $14_2$),
VBE: a potential difference across the base and emitter path of said first bipolar transistor (21), and
VBEtotal: sum of potential differences across the base emitter path of said first bipolar transistor (15) and said third bipolar transistors (22, 26).

**7.** The CMOS to ECL level shifter according to claim 4, charcterized in that said plurality of third bipolar transistors (22, 25) comprises:
a fourth bipolar transistor (22) whose collector emitter path is connected between said positive supply voltage (17) and said negative supply voltage (19) darlington-connected to said first bipolar transistor (15); and
a fifth bipolar transistor (26) whose collector emitter path is connected between said reference potential (GROUND) and said negative supply voltage (19) darlington-connected to said fourth bipolar transistor (22).

**Revendications**

**1.** Circuit à décalage d'un niveau CMOS à un niveau ECL pour convertir un niveau logique voulu d'un niveau CMOS en un niveau ECL, dans lequel:
un potentiel de référence (MASSE) fourni par une source de potentiel de référence correspond au niveau bas d'un signal d'entrée CMOS (S) provenant d'un circuit interne;
ledit signal d'entrée CMOS (S) est appliqué à la grille d'un transistor MOS (11) dont la source est connectée à la source de potentiel de référence (MASSE), et dont le drain est connecté à la base d'un premier transistor bipolaire à émetteur-suiveur connecté (15);
l'émetteur dudit premier transistor bipolaire (15) est connecté par l'intermédiaire d'une résistance de charge (18) à une source de tension d'alimentation négative (19) et une tension de source d'alimentation positive (17) effectivement égale ou supérieure au niveau haut du signal d'entrée CMOS est appliquée au collecteur dudit premier transistor bipolaire (15);
un courant de polarisation est appliqué à la base dudit premier transistor bipolaire (15) par un diviseur de tension (13,14) connecté entre la source de tension positive (17) et ladite source de potentiel de référence (MASSE);et
le signal de sortie ECL est sorti de l'émetteur (16) dudit premier transistor bipolaire (15).

**2.** Circuit à décalage d'un niveau CMOS à un niveau ECL selon la revendication 1, caractérisé en ce que:

ledit diviseur de tension comprend des première et deuxième résistances (13,14) connectées en série entre ladite source de tension positive (17) et ladite source de potentiel de référence (MASSE), et

un noeud (N) entre lesdites première et deuxième résistances (13,14) est connecté à la base dudit premier transistor bipolaire (15), la tension audit noeud (N) étant ainsi contrôlée par ledit transistor MOS (11).

**3.** Circuit à décalage d'un niveau CMOS à un niveau ECL selon la revendication 1, caractérisé en ce que ledit diviseur de tension comprend:

une première résistance (13) connectée entre ladite source de tension positive (17) et la base dudit premier transistor bipolaire (15);

des deuxième et troisième résistances (14$_1$,14$_2$) connectées en série entre la base dudit premier transistor bipolaire (15) et ladite source de potentiel de référence (MASSE); et

un deuxième transistor bipolaire (21) connecté entre la base dudit premier transistor bipolaire (15) et ladite source de potentiel de référence (MASSE), dont la base est connectée audit noeud entre lesdites deuxième et troisième résistances (14$_1$,14$_2$).

**4.** Circuit à décalage d'un niveau CMOS à un niveau ECL selon l'une quelconque des revendications 1 à 3, caractérisé en ce qu'il comprend en outre:

une pluralité de troisièmes transistors bipolaires (22,26) connectés selon une connexion de Darlington en cascade audit premier transistor bipolaire (15).

**5.** Circuit à décalage d'un niveau CMOS à un niveau ECL selon la revendication 2, caractérisé en ce que le signal de sortie ECL subit un décalage transitoire entre

$$\frac{R14 \cdot V_{CC}}{R13+R14} - V_{BE15} \quad et \quad - V_{BE15}$$

où,

$V_{CC}$: le potentiel de la tension positive d'alimentation (17),

R13 et R14: les valeurs de résistance desdites première et deuxième résistances (13,14), et

$V_{BE15}$: la différence de potentiel par la voie entre la base et l'émetteur dudit premier transistor bipolaire (15).

**6.** Circuit à décalage d'un niveau CMOS à un niveau ECL selon la revendication 4, caractérisé en ce que: le signal de sortie ECL subit un décalage transitoire entre

$$\frac{(R1+R2)V_{BE}}{R2} - V_{BE} \text{ totale} \quad et \quad - V_{BE} \text{ totale}$$

où,

R1 et R2: les valeurs de résistances desdites deuxième et troisième résistances (14$_1$,14$_2$),

$V_{BE}$: la différence de potentiel par la voie entre la base et l'émetteur dudit deuxième transistor bipolaire (21), et

$V_{BE}$totale: la somme des différences de potentiel par la voie entre la base et l'émetteur dudit premier transistor bipolaire (15) et celles desdits troisièmes transistors bipolaires (22, 26).

**7.** Circuit à décalage d'un niveau CMOS à un niveau ECL selon la revendication 4, caractérisé en ce que ladite pluralité des troisièmes transistors bipolaires (22,26) comprend:

un quatrième transistor bipolaire (22) dont la voie entre le collecteur et l'émetteur est connectée entre ladite source de tension positive (17) et ladite source de tension négative (19) selon une connexion de Darlington audit premier transistor bipolaire (15);et

un cinquième transistor bipolaire (26) dont la voie entre le collecteur et l'émetteur est connectée entre ladite source de potentiel de référence (MASSE) et ladite source de tension négative (19) selon une connexion de Darlington audit quatrième transistor bipolaire (22).

**Patentansprüche**

1. CMOS-ECL-Pegelschieber zum Umsetzen eines gewünschten logischen Pegels von CMOS nach ECL, wobei:
   - ein Bezugspotential (GROUND bzw. Masse) das von einer Bezugspotentialquelle eingespeist ist, dem niederen Pegel eines CMOS-Eingangssignales (S) von einer internen Schaltung entspricht;
   - das CMOS-Eingangssignal (S) am Gate eines MOSTransistors (11) angelegt ist, dessen Source mit dem Bezugspotential (GROUND) verbunden ist und dessen Drain an die Basis eines in Emitterfolgerschaltung verbundenen ersten Bipolartransistors (15) angeschlossen ist;
   - der Emitter des ersten Bipolartransistors (15) über einen Lastwiderstand (18) an eine negative Versorgungsspannung (19) angeschlossen ist und eine positive Versorgungsspannung (17), die im wesentlichen gleich oder höher ist als der hohe Pegel des CMOS-Eingangssignales, am Kollektor des ersten Bipolartransistors (15) liegt;
   - ein Vorspannungsstrom in die Basis des ersten Bipolartransistors (15) durch einen Spannungsteiler (13, 14) eingespeist ist, der zwischen der positiven Versorgungsspannung (17) und dem Bezugspotential (GROUND) angeschlossen ist; und
   - das ECL-Ausgangssignal von dem Emitter (16) des ersten Bipolartransistors (15) abgenommen ist.

2. CMOS-ECL-Pegelschieber nach Anspruch 1, dadurch gekennzeichnet, daß:
   der Spannungsteiler einen ersten und einen zweiten Widerstand (13, 14) aufweist, die in Reihe zwischen der positiven Versorgungsspannung (15) und dem Bezugspotential (GROUND) liegen, und ein Knoten (N) zwischen den ersten und zweiten Widerständen (13, 14) mit der Basis des ersten Bipolartransistors (15) verbunden ist, wobei eine Spannung an dem Knoten (N) durch den MOS-Transistor (11) gesteuert ist.

3. CHOS-ECL-Pegelschieber nach Anspruch 1, dadurch gekennzeichnet, daß der Spannungsteiler aufweist:
   einen ersten Widerstand (13), der zwischen der positiven Versorgungsspannung (17) und der Basis des ersten Bipolartransistors (15) angeschlossen ist;
   zweite und dritte Widerstände (141, 142), die in Reihe zwischen der Basis des ersten Bipolartransistors (15) und dem Bezugspotential (GROUND) verbunden sind; und
   einen zweiten Bipolartransistor (21), der zwischen der Basis des ersten Bipolartransistors (15) und dem Bezugspotential (GROUND) angeschlossen ist und dessen Basis mit dem Knoten zwischen den zweiten und dritten Widerständen ($14_1$, $14_2$) verbunden ist.

4. CMOS-ECL-Pegelschieber nach Anspruch 1 oder 3, gekennzeichnet durch eine Vielzahl von dritten Bipolartransistoren (22, 26), die in Darlington-Schaltung in Kaskade mit dem ersten Bipolartransistor (15) verbunden sind.

5. CMOS-ECL-Pegelschieber nach Anspruch 2, dadurch gekennzeichnet, daß:
   das ECS-Ausgangssignal einer transienten bzw. flüchtigen Verschiebung zwischen

$$\frac{R14 \cdot Vcc}{R13+R14} - VBE15 \text{ und } -VBE15$$

unterliegt, wobei:
Vcc: Potential der positiven Versorgungsspannung (17),
R13 und R14: Widerstandswerte des ersten bzw. zweiten Widerstandes (13, 14) und
VBE15: Potentialdifferenz über der Basis- und Emitterstrecke des ersten Bipolartransistors (15).

**6.** CMOS-ECL-Pegelschieber nach Anspruch 4, dadurch gekennzeichnet, daß:
das ECL-Ausgangssignal einer transienten bzw. flüchtigen Verschiebung zwischen

$$\frac{(R1+R2)VBE}{R2} - VBEtotal \text{ und } -VBEtotal$$

unterliegt, wobei:
R1 und R2: Widerstandswerte des zweiten bzw. dritten Widerstandes ($14_1$, $14_2$),
VBE: Potentialdifferenz über Basis- und Emitterstrecke des ersten Bipolartransistors (21) und
VBEtotal: Summe der Potentialdifferenzen über der Basis-Emitterstrecke des ersten Bipolartransistors (15) und der dritten Bipolartransistoren (22, 26).

**7.** CMOS-ECL-Pegelschieber nach Anspruch 4, dadurch gekennzeichnet, daß die Vielzahl der dritten Bipolartransistoren (22, 26) aufweist:
einen vierten Bipolartransistor (22), dessen Kollektor-Emitterstrecke zwischen der positiven Versorgungsspannung (17) und der negativen Versorgungsspannung (19) in Darlington-Schaltung mit dem ersten Bipolartransistor (15) verbunden ist; und
einen fünften Bipolartransistor (26), dessen Kollektor-Emitterstrecke zwischen dem Bezugspotential (GROUND) und der negativen Versorgungsspannung (19) in Darlington-Schaltung mit dem vierten Bipolartransistor (22) verbunden ist.

# F I G. 1

# F I G. 2

# F I G. 3

CMOS INPUT LEVEL (V)

ECL OUTPUT LEVEL (V)

ECL OUTPUT LEVEL

CMOS INPUT LEVEL

TIME (ns) ⟶

D1

D2

EP 0 239 841 B1